# EUROPÄISCHE PATENTSCHRIFT

(11) **EP 1 891 704 B1**
(45) Veröffentlichungstag und Bekanntmachung des Hinweises auf die Patenterteilung: **09.02.2011**
(21) Anmeldenummer: 07717681.6
(22) Anmeldetag: 03.04.2007
(51) Int. Cl.: H01R 9/26

(54) **MEHRPOLIGER BLITZSTROM- UND/ODER ÜBERSPANNUNGSABLEITER IN REIHENKLEMMAUSFÜHRUNG**
MULTIPOLAR LIGHTNING STRIKE CURRENT ARRESTER AND/OR SURGE ARRESTER IN TERMINAL EMBODIMENT
PARAFOUDRE MULTIPOLE ET/OU PROTECTEUR CONTRE LES SURTENSIONS DE FOUDRE DANS UME REALISATION DE BARRETTE DE BORNES

(30) Priorität: 09.05.2006 DE 102006021607; 24.07.2006 DE 102006034164
(43) Veröffentlichungstag der Anmeldung: 27.02.2008
(73) Patentinhaber: DEHN + SÖHNE GMBH + CO KG, 92318 Neumarkt/Opf (DE)
(72) Erfinder: IGL, Peter, 90602 Seligenporten (DE); LACHNER, Helmut, 92318 Neumarkt (DE); KRÄMER, Herbert, 91180 Heideck (DE); SELLERER, Markus, 92318 Neumarkt (DE)
(74) Vertreter: Meissner, Bolte & Partner
(86) Internationale Anmeldenummer: PCT/EP2007/053199
(87) Internationale Veröffentlichungsnummer: WO 2007/128628

(56) Entgegenhaltungen:
- DE-C1- 10 001 667
- US-A- 4 922 374

## Beschreibung

Die Erfindung betrifft einen mehrpoligen Blitzstram und/oder Überspannungsableiter in Reihenklemmausführung zum Schutz von Geräten und Anlagen der Informationstechnik, bestehend aus Basisteil als Durchgangsklemne, in das Basisteil einsetzbare Steckmodule mit Schutzelementen und Mitteln zur Hutschienenmontage, wobei im Basisteil Federkontakte für das jeweilige Steckmodul ausgebildet sind und das Steckmodul ein haubenförmiges Gehäuse aufweist, welches in seinem Inneren mindestens eine Leiterplatte aufnimmt, die die Schutzelemente trägt, gemäß Oberbegriff des Patentanspruchs 1.

Schutzgeräte für Anlagen und Geräte der Informationstechnik gehören seit längerer Zeit zum Stand der Technik.

Beispielsweise seien hier Schutzgeräte der Serie "Blitzductor" (eingetragene Marke) der Firma DEHN & SÖHNE GmbH + Co. KG, Neumarkt, genannt. Bei derartigen Blitzstran- und Überspannungsableitern, die als Standardgeräte in Reihenklemmtechnik zur Verfügung stehen, sind zweipolige, aber auch vierpolige Varianten am Markt erhältlich. Die Überspannungsschutzgeräte können hier als Blitzstrambleiter, Kanbiableiter oder als Überspannungsableiter eingesetzt werden. Die bekannten Geräte ermöglichen den koordinierten Einsatz im EMV-orientierten Blitzschutzzonenkonzept nach VDE 0185-103 mit einer der EMV-Störfestigkeit angepassten Schutzwirkung für Geräte der Fermelde-, MSR- und Datentechnik.

Die vorbekannten Überspannungsableiter sind durch einen zweiteiligen Aufbau mit einem Basisteil als Durchgangsklemme zur Aufnahme der Schutzmodule und mit auswählbaren Überspannungsschutzmodulen ausgestattet. Durch geringe Baubreite ergibt sich eine kompakte, platzsparende Bauweise. Eine Signalunterbrechung beim Wechseln der Module tritt nicht ein und es weist das Basisteil eine integrierte Schirm-Anschlußklemne auf. Die Schirmerdung ist direkt und indirekt möglich. Die Erdung erfolgt über einen Tragfuß mit Schnappbefestigung durch bevorzugte Hutschienenmontage.

Aus der DE 196 15 729 B4 ist darüber hinaus eine Überspannungsschutzanordnung zum Schutz eines Endgeräts gegen Überspannungen vorbekannt, wobei die notwendigen Schutzelemente und Mittel zur Entkopplung auf einer Trag- oder Leiterplatte befindlich sein. Eine derartige Leiterplatte ist in entsprechende Schutzbausteinen kleinerer Abmessungen einbringbar, so dass keine Nachteile für den insgesamt notwendigen Bauraum resultieren.

Auch die Überspannungsschutzgeräte der Firma Phoenix Contact GmbH & Co. KG, beispielsweise van Typ MCR-PLUGTRAB sind in Ausführung Reihenklemme mit mehrstufigem Überspannungsschutz erhältlich, wobei im Inneren des Ableiters eine Leiterplatte befindlich ist, die die Schutzelemente trägt. Bei diesen bekannten, auch kaskadierbaren Überspannungsschutzelementen erfolgt die Kontaktierung mit einem Basisteil unterbrechungsfrei und impedanzneutral, wobei hierfür separate massive stiftartige Steckkontakte am Steckteil vorgesehen sind. Ein mehrpoligen Blitzstrom-und/oder Überspannungsableiter gemäβ dem Oberbegriff des Anspruchs 1 ist aus US 4 922 374 A bekannt.

Aus dem Vorgenannten ist es daher Aufgabe der Erfindung, einen weiterentwickelten mehrpoligen Blitzstram- und/oder Überspannungsableiter- in Reihenklemmausführung zum Schutz von Geräten und Anlagen der Informationstechnik anzugeben, welcher einerseits über einen minimalen Bauraum verfügt und der andererseits im Herstellungsprozess kostengünstig fertigbar ist. Weiterhin soll der neuartige Überspannungsableiter nur eine minimierte Teileanzahl besitzen und eine hohe Impulsstramfestigkeit aufweisen.

Die Lösung der Aufgabe der Erfindung erfolgt durch einen mehrpoligen Blitzstrom und/oder Überspannungsableiter in Reihenklemmtechnik zum Schutz von Geräten und Anlagen der Informationstechnik gemäß Merkmalskanbination nach Patentanspruch 1, wobei die Unteransprüche mindestens zweckmäßige Ausgestaltungen und Weiterbildungen darstellen.

Erfindungsgemäß wird zunächst im Gehäuse des Steckmoduls der Gesamtanordnung ein Trägerrahmen angeordnet, wobei an den jeweiligen Außenseiten des Trägerrahmen je eine Leiteiplatte befindlich ist, die in ihrer Endposition, d.h. im montierten Zustand parallel zueinander stehen.

Zwischen diesen beiden außenseitig des Trägerrahmens befindlichen Leiterplatten ist eine dritte Leiteiplatte derart angeordnet, dass durch den Trägerrahmen und den sich hierdurch ergebenden Abstand der Leiterplatten untereinander, die notwendigen Kriech- und Luftstrecken zwischen den Leiterplatten und den dort befindlichen Schutzelementen realisiert werden.

Das Gehäuse umschließt die sich so ergebende Sandwichanordnung aus den Leiterplatten und dem Trägerrahmen und fixiert die Einzelteile dieser Baugruppe.

Der Trägerrahmen weist insbesondere eine Rechteckform auf und besitzt eine Außenkontur mit Rücksprüngen oder Absätzen als Anschlag für entsprechend kanplementäre Ausbildungen der jeweiligen Leiterplatten. Diese Rücksprünge dienen auch als Kodierung, um Verwechslungen bei einzusetzenden Leiterplatten auszuschließen

Der Trägerrahmen weist an seiner Oberseite mindestens eine schlitzförmige Öffnung auf, um die dritte Leiterplatte führend aufzunehnen. Montageseitig wird also die dritte Leiterplatte durch die schlitzförmige Öffnung gegen Verschieben gesichert. Um der dritten Leiterplatte unterseitig Halt zu bieten, besitzt der Trägerrahmen bevorzugt einen dementsprechenden Quersteg, der als Anschlag wirkt.

An den Gehäuseschmalseiten sind jeweils Mittel zum lösbar rastenden Verbinden mit komplementären Rastausnehmungen am Basisteil vorhanden. Diese Rastmittel verhindern ein unerwünschtes Herauslösen des Steckmoduls aus dem Basisteil.

Die von den Außenseiten des Trägerrahmens fixierten Leiterplatten weisen aus dem Gehäuse des Steckmoduls zapfenartig herausragende, integral geformte Abschnitte auf, welche Kontaktzungen bilden.

Die herausragenden, Kontaktzungen bildenden Abschnitte der außenseitig befindlichen Leiteiplatten sind mit ihrer leitend beschichteten Seite zueinander weisend gerichtet. Um hohe Impulsströme über die Kontaktierung zum Basisteil zu führen, sind die Kontaktzungen mit einer Nickelschicht überzogen.

Analog der Ausbildung der Kontaktzungen sind im Basisteil parallel verlaufende Schlitzöffnungen vorgesehen, welche die Kontaktzungen oder die jeweiligen Kontaktzungenenden des Steckmoduls aufnehmen.

Im Basisteil ist im Bereich der Schlitzöffnungen jeweils in Steckrichtung orientiert eine Leiterplatte angeordnet. Der jeweiligen Leiterplatte ist jeweils mindestens ein federnder Adernbügel zugeordnet, wobei bei nicht gestecktem Steckmoduls die jeweiligen Adernbügel in Kontakt mit dem jeweiligen leitfähigen Abschnitt der Basisteil-Leiterplatte stehen und dieser Kontakt beim Einsetzen des Steckmoduls durch die Kontaktzungen unterbrochen sowie eine Verbindung der Kontaktzungen des Steckmoduls mit den Adernbügeln hergestellt ist.

Die Dicke der jeweiligen Trägerschicht der Leiterplatten-Kontaktzunge bildet die Isolierung zwischen Adernbügel und Basisteil-Leiterplatte.

Die Adernbügel weisen im Längsschnitt eine V- oder U-Form mit zwei gegenüberliegenden Schenkeln auf, wobei ein Schenkel mit der Kontaktzunge oder der Basisteil-Leiterplatte und der weitere Schenkel mit dem jeweiligen Außenanschluss in elektrische Verbindung gelangt oder steht.

Bevorzugt sind die Kontaktflächen der Adernbügel mit Schlitzen versehen. Diese Schlitze können parallel ausgeführt werden und sind im zur Kontaktfläche weisenden Schenkel von Schenkelende ausgehend bis in den Schenkelverbindungsbereich geführt.

Die dritte Leiterplatte weist eine Einrichtung zur drahtlosen Fehler- und Zustandsüberwachung z.B. in Form eines RFID-Transponders auf und enthält gegebenenfalls Mittel zur Temperaturüberwachung der auf den übrigen Leiterplatten befindlichen Schutzelemente. Diese Mittel können Temperatursensoren sein, die jeweils nahe, insbesondere gegenüberliegend der Schutzelemente befindlich sind.

Wenn aus elektrischen Gründen notwendig, kann zur elektrischen Verbindung zwischen den außenseitigen Leiterplatten ein Verbindungs-Federkontaktbügel vorgesehen sein. In diesem Fall ist es zweckmäßig, die dritte Leiterplatte flächenmäßig kleiner als die außenseitigen Leiterplatten auszubilden, um eine ungehinderte Kontaktgabe über den Federkontaktbügel sicherzustellen.

An der Hutschienen-Befestigungsunterseite des Basisteils weist dieses eine Öffnung auf, welche einen Bügel-Erdungskontakt freigibt, der mit der Hutschiene kontaktseitig in Verbindung gelangt.

Der Bügel-Erdungskontakt weist zwei sich gegenüberliegende Schenkel auf, wobei der erste Schenkel mit dem Erdanschluss im Basisteil kontaktiert ist und der zweite Schenkel mit der Hutschiene in Verbindung steht, und zwar derart, dass bei Stranfluss die resultierende magnetische Kraft den Kontaktanpressdruck erhöht.

Im Boden des Basisteils ist eine in Steckrichtung des Moduls orientierte Feder, insbesondere Schraubenfeder eingesetzt, welche beim Einstecken des Moduls durch einen an dessen Boden vorgesehenen Stift gespannt wird. Diese gespannte Feder dient als Kraftspeicher zum leichteren Entfernen des Moduls bei entsprechender Notwendigkeit.

Die Erfindung soll nachstehend anhand eines Ausführungsbeispiels sowie unter Zuhilfenahme von Figuren näher erläutert werden.

Hierbei zeigen:

Fig. 1 eine perspektivische Darstellung eines auf einer Hutschiene befestigten Basisteils mit noch nicht in diesem fixierten Steckmodul;

Fig. 2 eine Explosivdarstellung der wesentlichsten Baugruppen des Steckmoduls;

Fig. 3 eine Explosivdarstellung der wesentlichsten Baugruppen des Basisteils;

Fig. 4 Prinzipdarstellungen der Ausbildung der Adernbügel im Basisteil, und zwar im Zustand nicht eingesetztes Steckmodul (oberer Teil der Fig. 4) und gestecktem Modul (unterer Teil der Fig. 4);

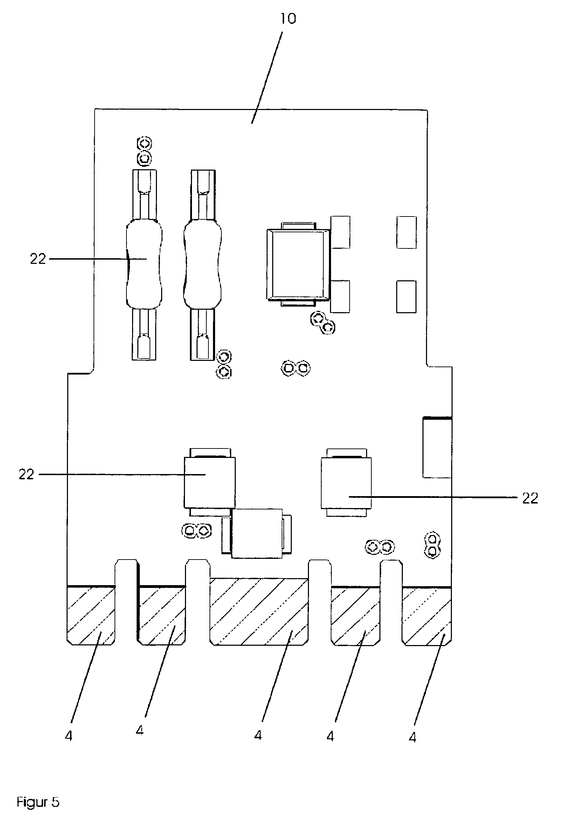

Fig. 5 eine Draufsicht auf eine der außenseitig des Trägerrahmens befindlichen Leiterplatte mit Schutzelementen und Kontaktzungen;

Fig. 6 eine perspektivische Darstellung eines Adernbügels mit geschlitztem Kontakt sowie eine Darstellung der sich ergebenden Kraftwirkung bei Stramfluss zur Erhöhung der Anpresskräfte;

Fig. 7 eine Prinzipdarstellung der Ausführung des Bügel-Erdungskontakts im Basisteil und

Fig. 8 eine Prinzipdarstellung der Ausführungsform des Federkontaktbügels zur elektrischen Verbindung zwischen den beiden außenseitigen Leiterplatten.

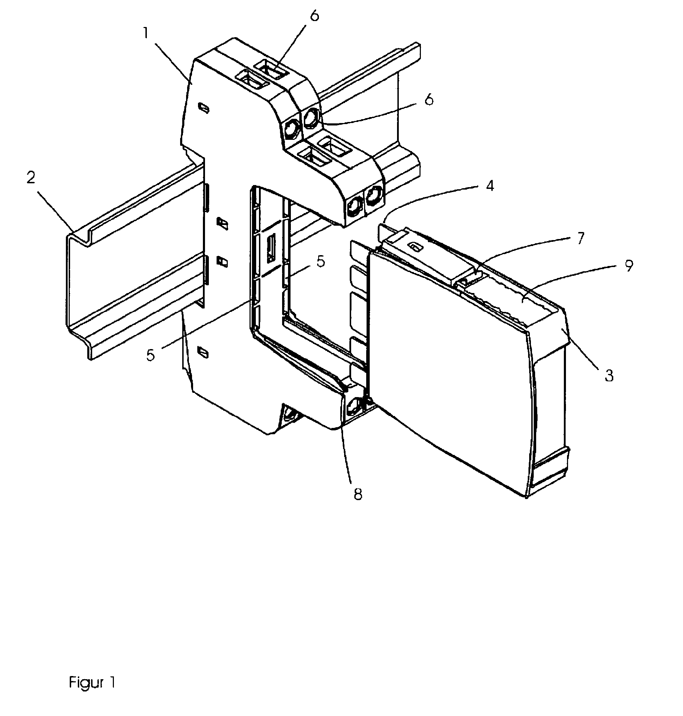

Wie anhand der Fig. 1 ersichtlich, umfasst der erfindungsgemäße mehrpolige Blitzstram- und/oder Überspannungsableiter- in Reihenklemmausführung zunächst ein Basisteil 1, das an einer Hutschiene 2 form- und kraftschlüssig befestigbar ist.

Das Basisteil 1 nimmt ein Steckmodul 3 auf, an dessen Unterseite Kontaktzungen 4 befindlich sind.

Diese Kontaktzungen 4 greifen in komplementäre Schlitzöffnungen 5 im Basisteil 1 ein.

Der Außenanschluss erfolgt durch übliche Schraubklemnverbindungen 6 am Basisteil 1. Bei im Basisteil 1 vollständig eingesetztem Steckmodul 3 rastet eine Nase 7 in einen entsprechenden Rücksprung 8 ein. Über das Ausüben einer Druckkraft auf die gegenüberliegenden Betätigungsflächen 9 kann diese Rastverbindung gelöst werden.

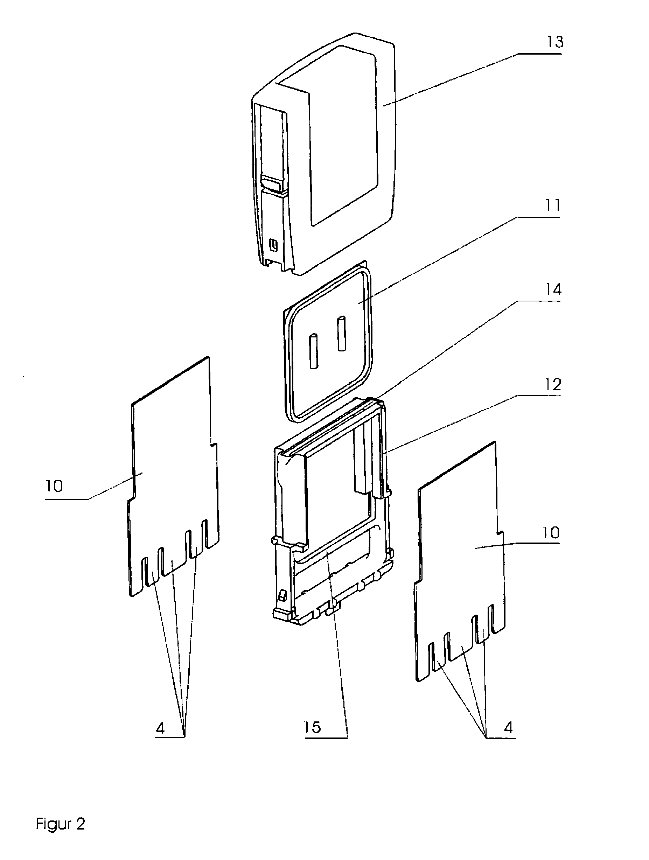

Der Aufbau des Steckmoduls soll anhand der Fig. 2 näher erläutert werden.

Die Bauelemente für den Überspannungsschutz eines vierpoligen Schaltkreises werden hier auf zwei Leiterplatten 10 (außenseitige Leiterplatten) aufgeteilt.

Bei Schaltungen für symmetrische Schnittstellen werden die jeweils zugehörigen Adern auf einer Leiterplatte angeordnet.

Eine dritte Leiterplatte 11 sitzt zwischen den beiden Leiterplatten 10 und trägt insbesondere eine Schaltung für die Zustandskontrolle des Überspannungsableiters, bevorzugt mit einer RFID-Schnittstelle zur berührungslosen Zustandsabfrage.

Ein Trägerrahmen 12 nimmt die Leiterplatten 10 und 11 auf. Der Trägerrahmen 12 stellt auch die notwendigen Luft- und Kriechstrecken sicher und ermöglicht die Positionierung von Temperatursensoren (nicht gezeigt) für die Zustandskontrolle nahe zu den zu überwachenden Bauteilen.

Das haubenartige Gehäuse 13 fixiert die Leiterplatten 10 und 11 in Verbindung mit dem Trägerrahmen.

Wie bereits zur Fig. 1 erläutert, sind an den schmalen Seiten des Gehäuses 13 Rastelemente ausgebildet, die eine Verriegelung des Ableitermoduls im Basisteil ermöglichen.

Die Oberseite des Trägerrahmens 12, der eine im wesentlichen Rechteckform aufweist und eine Außenkontur mit Rücksprüngen oder Absätzen als Anschlag und Verwechslungsschutz für eine komplementäre Ausbildung der jeweiligen Leiterplatten besitzt, kann eine schlitzförmige Öffnung 14 umfassen, um die dritte Leiterplatte 11 führend aufzunehmen. Dabei bildet ein Quersteg 15 für diese dritte Leiterplatte 11 einen unteren Anschlag.

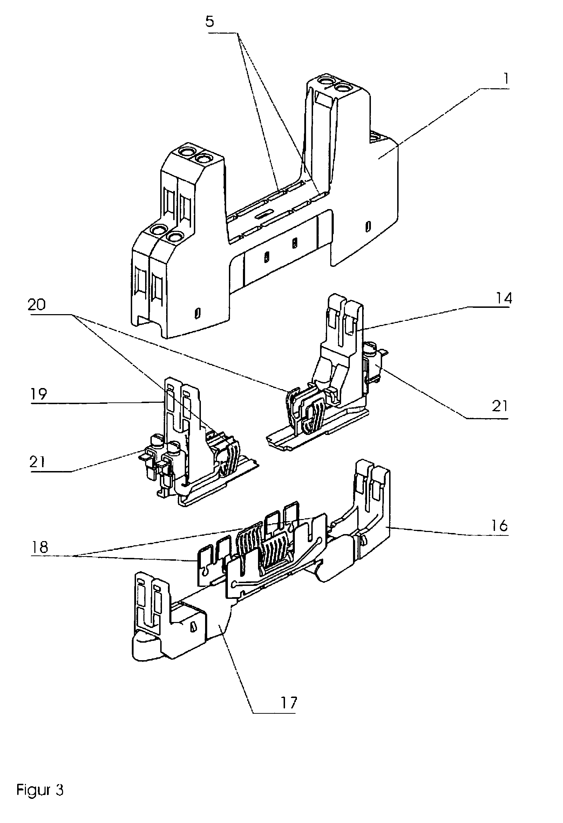

Das Basisteil 1 gemäß Fig. 3 weist eine Außenkontur im wesentlichen derjenigen des Standes der Technik auf, allerdings mit den bereits erwähnten Schlitzöffnungen 5, die im Verbindungsbereich zwischen den hervorstehenden Schenkeln im wesentlichen in einer Linie und parallel zueinander orientiert sind.

Ein Bodenteil 16 dient als Träger für den Erdkontakt 17 und für Leiterplatten 18. Weiterhin ist ein durch eine Feder vorgespanntes Rastelement integriert, das die Befestigung auf der Hutschiene gewährleistet.

Zwei Einsätze 19 tragen Adernbügel 20 für die äußeren Anschlussklemmen 21.

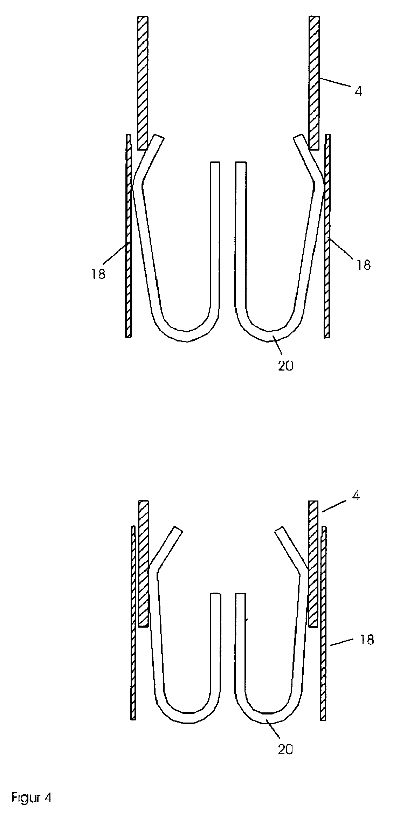

Wie anhand der Prinzipdarstellung nach Fig. 4 erkennbar (oberer Teil der Abbildung nach Fig. 4), liegen die Kontakte der Adernbügel 20 an den Kontaktflächen der im Basisteil integrierten Leiterplatten 18 auf.

Über diese Leiterplatten 18 werden die eingangsseitigen Adernbügel 20 mit den ausgangsseitigen Adernbügeln verbunden.

Wird ein Steckmodul in das Basisteil eingesetzt, werden durch die Kontaktzungen 4 die Kontaktflächen von der Leiterplatte 18 im Basisteil abgehoben und gleichzeitig mit den Kontaktflächen der Kontaktzungen 4 des Steckmoduls verbunden.

Dadurch ist der Stromkreis über das Steckmodul mit den Adernbügeln 20 des Basisteils geschlossen.

Die Adernbügel 20 erfüllen somit die Funktion Schalten und Kontaktabgabe gleichzeitig.

Durch die Leiterplatten 10 des Steckmoduls 3 wird gleichzeitig die notwendige Öffnungsweite des Kontakts zur Leiterplatte 18 des Basisteils erreicht. Zwischen Eingang und Ausgang ist wie erkennbar zweifach die Leiterplattendicke als feste Isolierung vorhanden.

Die Leiterplatten 10 weisen durch die Ätzstruktur entsprechend elektrisch verbundene Schutzelemente 22 auf.

Die Kontaktzungen 4 der jeweiligen Leiterplatte 10 stellen sich als aus der Leiterplatte herausragende Fortsätze dar. Es werden also die Kontaktzungen 4 gleichzeitig mit der Leiterplatte 10 gebildet, die die für den Überspannungsschutz notwendigen Schutzelemente 22 trägt. Durch eine harte Nickelbeschichtung auf den Kontaktzungen 4 ist die entsprechende Kontaktfläche in der Lage, die für den jeweiligen Ableiter geforderten Stoßströme zu führen, was bei einer üblichen weichen Zinnschicht mit darunter liegendem Kupfer nicht der Fall ist.

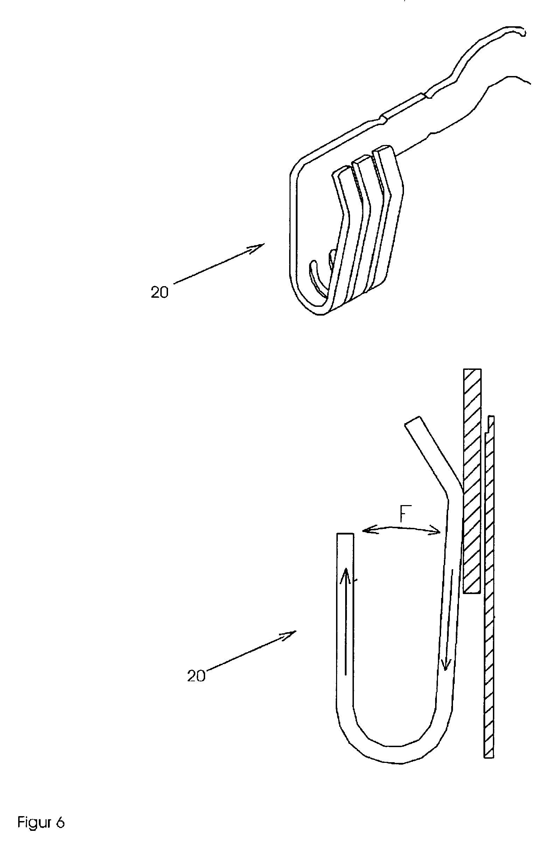

Die Kontaktflächen der Adernbügel 20 sind gemäß Fig. 6 (obere Abbildung) geschlitzt ausgeführt, wodurch eine größere Auflagefläche erreicht wird.

Bei einem einzelnen großflächigen Kontakt entsteht im ungünstigsten Fall nur ein einziger Auflagepunkt.

Durch wie in der Fig. 6 dargestellte zwei Schlitze werden drei Einzelkontakte erreicht, die auch ein günstigeres Kontakt-Federungsverhalten aufweisen. Ähnlich ist der Erdkontakt-Adernbügel ausgeführt, allerdings sind bei diesem sechs Einzelkontakte realisiert.

Die Ausbildung der Adernbügel 20 ist so vorgenommen, dass sich zwei im wesentlichen ein U bildende Schenkel gegenüberstehen.

Durch die magnetische Kraft F, die beim gegensinnigen Stranfluss (Pfeildarstellung) durch die beiden Schenkel entsteht, wird der Kontakt an die Kontaktfläche des Ableitermoduls gepresst, wobei die Andruckkraft F dabei direkt proportional zur Stramstärke ist.

Die Befestigung des Basisteils 1 auf der Hutschiene 2 hat gleichzeitig die Aufgabe, den Ableitstrom des Überspannungsschutzgeräts sicher auf die Hutschiene zu führen.

Auch hier ist eine vernickelte Oberfläche vorhanden, um ein Ausschmelzen im Kontaktbereich zu verhindern.

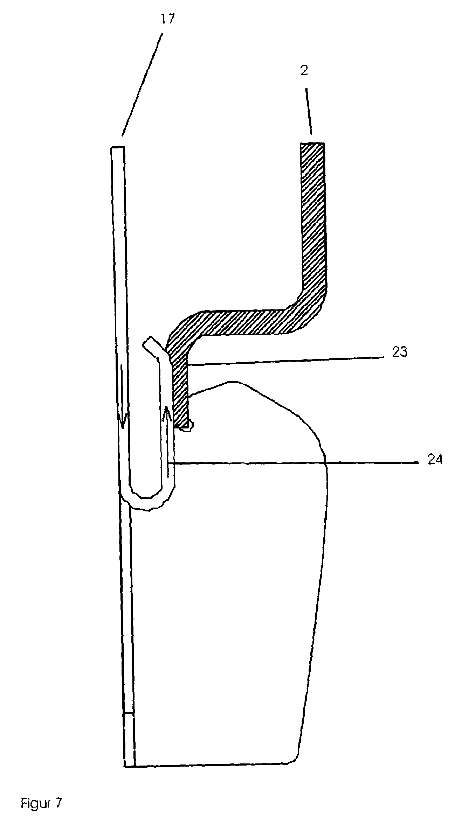

Aus dem Erdkontakt 17 ist ein Federkontakt (siehe Fig. 7) ausgeprägt, wobei die Hutschiene 2 mit dem Hutschienenende 23 gegen die Schulter 24 des Erdungskontakts gedrückt wird.

Auch hier ist die Ausbildung des Federkontakts so vorgenammen, dass sich zwei Schenkel gegenüberstehen und durch die magnetische Kraft sich eine Erhöhung des Kontaktanpressdrucks bei Stranfluss einstellt.

Bei einer Überspannungsschutzbeschaltung von vier Leiterkreisen ist es notwendig, zwischen allen Leitern ein Feinschutzelement anzuordnen.

Da bei dem Ausführungsbeispiel jeweils zwei Adern auf einer Leiterplatte beschaltet werden, ist eine Verbindung zwischen den beiden Leiterplatten 10 des Steckmoduls notwendig.

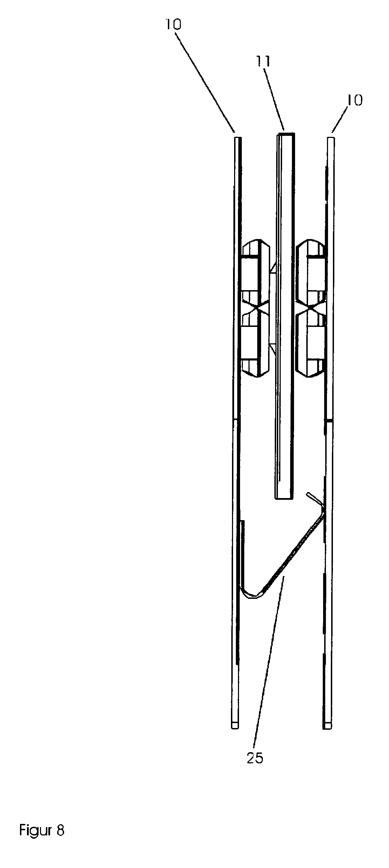

Realisiert wird dies unter Hinweis auf Fig. 8 mittels eines Federkontaktbügels 25.

Ein Ende des Federkontaktbügels 25 wird auf einer Leiterplatte verlötet, wobei das freie Ende des Federkontaktbügels 25 mit der gegenüberliegenden Leiterplatte und einer dort vorhandenen leitfähigen Fläche in Kontakt steht.

Aus der Darstellung nach Fig. 8 wird deutlich, dass insbesondere bei Notwendigkeit eines Federkontaktbügels 25 in zweckmäßiger Weise die Flächenausdehnung der Leiterplatte 11 kleiner als diejenige der Außenseiten-Leiterplatten 10 ist.

Bezugszeichenliste

1 Basisteil

2 Hutschiene

3 Steckmoduls

4 Kontaktzunge

5 Schlitzöffnung

6 Schraub-/Klenmverbindung

7 Nase

8 Rücksprung

9 Betätigungsfläche

10 erste und zweite Leiterplatte

11 dritte Leiterplatte

12 Trägerrahmen

13 Gehäuse

14 schlitzförmige Öffnung

15 Quersteg

16 Bodenteil

17 Erdkontakt

18 Leiterplatte im Basisteil

19 Einsatz

20 Adernbügel

21 äußere Anschlussklemme

22 Schutzelement

23 Hutschienenende

24 Schulter

25 Federkontaktbügel

## Patentansprüche

1. Mehrpoliger Blitzstrom- und/oder Überspannungsableiter in Reihenklemmausführung zum Schutz von Geräten und Anlagen der Informationstechnik, bestehend aus Basisteil (1) als Durchgangsklemme, in das Basisteil (1) eisetzbare Steckmodule (3) mit Schutzelementen (22) und Mitteln zur Hutschienenmontage, wobei im Basisteil (1) Federkontakte für das jeweilige Steckmodul (3) ausgebildet sind und das Steckmodul (3) ein haubenförmiges Gehäuse (13) aufweist, welches in seinem Inneren mindestens eine Leiterplatte (10) aufnimmt, die die Schutzelemente (22) trägt, **dadurch gekennzeichnet**, das
im Gehäuse des Steckmoduls (3) ein Trägerrahmen (12) aufgenommen ist, wobei an den jeweiligen Außenseiten des Trägerrahmens (12) je eine Leiterplatte (10) befindlich ist, zwischen denen, durch den Trägerrahmen (12) gehalten, eine dritte Leiterplatte (11) derart angeordnet ist, das durch den Trägerrahmen (12) die notwendigen Kriech- und Luftstrecken zwischen den parallel orientierten Leiterplatten (10; 11) und den dort befindlichen Schutzelementen (22) realisiert werden und weiterhin das Gehäuse (13) die Sandwichanordnung aus Leiterplatten (10; 11) und Trägerrahmen (12) umschließend fixiert.

2. Überspannungsableiter nach Anspruch 1,
**dadurch gekennzeichnet**, das;
der Trägerrahmen (12) eine Rechteckform aufweist und eine Außenkontur mit Rücksprünge oder Absätzen als Anschlag und Verwechslungschutz für eine komplementäre Ausbildung der jeweiligen Leiterplatten (10; 11) besitzt.

3. Überspannungsableiter nach Anspruch 2,
**dadurch gekennzeichnet, dass**
im Trägerrahmen (12) mindestens eine schlitzförmige Öffnung (14) vorgesehen ist, um die dritte Leiterplatte (11) führend aufzunehmen.

4. Überspannungsableiter nach einem der vorangegangenen Ansprüche,
**dadurch gekennzeichnet, dass**
an den Gehäuseschmalseiten jeweils Mittel zum lösbar rastenden Verbinden mit komplementären Rastausnehmungen am Basisteil (1) vorhanden sind.

5. Überspannungsableiter nach einem der vorangegangenen Ansprüche,
**dadurch gekennzeichnet, dass**
die von den Außenseiten des Trägerrahmens (12) fixierten Leiterplatten (10) aus dem Gehäusse (13) des Steckmoduls (3) zapfenartig herausragende Abschnitte aufweisen, welche Kontaktzungen (4) bilden.

6. Überspannungsableiter nach Anspruch 5,
**dadurch gekennzeichnet, dass**
die herausragenden Abschnitte mit ihrer leitend beschichteten Seite zueinander gerichtet sind.

7. Überspannungsableiter nach Anspruch 5 oder 6,
**dadurch gekennzeichnet, dass**
die Kontaktzungen (4) eine Nickelbeschichtung aufweisen.

8. Überspannungsableiter nach einem der Ansprüche 5 bis 7,
**dadurch gekennzeichnet, dass**
im Basisteil (1) parallel verlaufende Schlitzöffnungen (5) vorgesehen sind, welche die Kontaktzungen (4) oder Kontaktzungenenden des Steckmoduls (3) aufnehmen.

9. Überspannungsableiter nach Anspruch 8,
**dadurch gekennzeichnet, dass**
im Basisteil (1) im Bereich der Schlitzöffnungen (5) jeweils in Steckrichtung orientierte Leiterplatten (18) angeordnet sind, denen jeweils mindestens ein federnder Adernbügel (20) zugeordnet ist, wobei bei nicht gestecktem Steckmodul (3) die jeweiligen Adernbügel (20) in Kontakt mit dem jeweiligen leitfähigen Abschnitt der Basisteil-Leiterplatten (10) stehen und dieser Kontakt beim Einsetzen des Steckmoduls (3) durch die Kontaktzungen (4) unterbrochen sowie eine Verbindung mit Kontaktzungen (4) mit den Adernbügeln (20) hergestellt ist und die Dicke der jeweiligen Trägerschicht der Leiteiplatten-Kontaktzunge die Isolierung zwischen Adernbügel (20) und Basisteil-Leiterplatte ( 18) bildet.

10. Überspannungsableiter nach Anspruch 9,
**dadurch gekennzeichnet, dass**
die Adernbügel (20) im Längsschnitt eine V- oder U-Form mit zwei gegenüberliegenden Schenkeln aufweisen, wobei ein Schenkel mit der Kontaktzunge (4) oder der Basisteil-Leiterplatte (18) und der weitere Schenkel mit dem jeweiligen Außenanschluss in elektrische Verbindung gelangt oder steht.

11. Überspannungsableiter nach Anspruch 9 oder 10,
**dadurch gekennzeichnet, dass**
die Kontaktflächen der Adernbügel (20) mit Schlitzen, insbesondere Längsschlitzen versehen sind.

12. Uberspannungsableiter nach Anspruch 11,
**dadurch gekennzeichnet, dass**
die Schlitze parallel ausgeführt sind und im zur Kontaktfläche weisenden Schenkel vom Schenkelende ausgehend bis in den Schenkelverbindungsbereich geführt sind.

13. Überspannungsableiter nach einem der vorangegangenen Ansprüche,
**dadurch gekennzeichnet, dass**
die dritte Leiterplatte (11) eine Einrichtung zur drahtlosen Fehler- und Zustandsüberwachung aufweist und/oder Temperatursemoren umfasst, die jeweils nahe, insbesondere gegenüberliegend der Schutzelemente (22) auf den außenseitigen Leiterplatten (10) befindlich sind.

14. Überspannungsableiter nach einem der vorangegangenen Ansprüche,
**dadurch gekennzeichnet, dass**
zur elektrischen Verbindung zwischen den außenseitigen Leiterplatten (10) ein Federkontaktbügel (25) vorgesehen ist.

15. Überspannungsableiter nach Anspruch 14,
**dadurch gekennzeichnet, dass**
die dritte Leiterplatte (11) flächenmäßig kleiner als die außenseitigen Leiterplatten (10) ausgebildet ist.

16. Überspannungsableiter nach einem der vorangegangenen Ansprüche,
**dadurch gekennzeichnet, dass**
an der Hutschienen-Befestigungsunterseite des Basisteils (1) dieses eine Öffnung aufweist, welche einen Bügel-Erdungskontakt (17;24) freigibt, der mit der Hutschiene (2) in Verbindung gelangt.

17. Überspannungsableiter nach Anspruch 16,
**dadurch gekennzeichnet, dass**
der Bügel-Erdungskontakt zwei sich gegenüberliegende Schenkel aufweist, wobei der erste Schenkel mit dem Erdungsanschlus (17) im Basisteil (1) kontaktiert ist und der zweite Schenkel (24) mit der Hutschiene (2;23) in Verbindung steht, derart, dass bei Stromfluss die resultierende magnetische Kraft den Kontaktanpressdruck erhöht.

18. Überspannungsableiter nach einem der vorangegangenen Ansprüche,
**dadurch gekennzeichnet, dass**
im Boden des Basisteils (1) eine in Steckrichtung des Moduls orientierte Feder eingesetzt ist, welche beim Einstecken des Moduls durch einen, an dessen Boden vorgesehenen Stift gespannt wird und als Kraftspeicher zum leichteren Entfernen des Moduls wirkt.

## Claims

1. A multipolar lightning current and/or surge arrester embodied as a series terminal for the protection of information technology devices and systems, consisting of a base part (1) as a lead-through terminal, plug-in modules (3) insertable into the base part (1) with protective elements (22) and means designed for top hat rail mounting, wherein spring contacts for the respective plug-in module (3) are formed in the base part (1) and the plug-in module (3) comprises a cap-shaped housing (13), which accommodates in its interior at least one printed circuit board (10) carrying the protective elements (22), **characterized in that**
a support frame (12) is received in the housing of the plug-in module (3), wherein a printed circuit board (10) is each provided on the respective exteriors of the support frame (12), between which, held by the support frame (12), a third printed circuit board (11) is arranged in such a way that, by the support frame (12), the necessary creepage distances and air gaps are realized between the printed circuit boards (10; 11), which are oriented in parallel, and the protective elements (22) located thereon, and wherein further the housing (13) fixes the sandwich structure comprised of printed circuit boards (10; 11) and the support frame (12) in an enclosing manner.

2. The surge arrester according to claim 1,
**characterized in that**
the support frame (12) is of a rectangular shape and has an outer contour with recesses or shoulders serving as limit stop and confusion protection with respect to a complementary shape of the respective printed circuit boards (10; 11).

3. The surge arrester according to claim 2,
**characterized in that**
at least one slot-shaped opening (14) is provided in the support frame (12) so as to receive the third printed circuit board (11) in a guided manner.

4. The surge arrester according to one of the preceding claims,
**characterized in that**
on each of the narrow sides of the housing means are provided for a detachable locking connection with complementary snap-in locking recesses provided on the base part (1).

5. The surge arrester according to one of the preceding claims,
**characterized in that**
the printed circuit boards (10) fixed in position by the exteriors of the support frame (12) are provided with sections, which form contact tongues (4) and which project out of the housing (13) of the plug-in module (3) in a peg-shaped manner.

6. The surge arrester according to claim 5,
**characterized in that**
the projecting sections are mounted to face each other with their conductively coated side.

7. The surge arrester according to claim 5 or 6,
**characterized in that**
the contact tongues (4) are coated with a nickel layer.

8. The surge arrester according to one of claims 5 to 7,
**characterized in that**
slotted openings (5) extending in parallel are provided in the base part (1), which receive the contact tongues (4) or contact tongue ends of the plug-in module (3).

9. The surge arrester according to claim 8,
**characterized in that**
in the base part (1), in the region of the slotted openings (5), printed circuit boards (18) oriented in the plug-in direction are mounted, each of which is assigned at least one resilient spring clip (20), wherein, when the plug-in module (3) is not plugged in, the respective spring clips (20) are in contact with the respective conductive section of the printed circuit boards (10) of the base part, and this contact is broken by the contact tongues (4) when the plug-in module (3) is inserted, and a connection of the contact tongues (4) with the spring clips (20) is produced, and the thickness of the respective substrate of the contact tongue of the printed circuit board forms the insulation between the spring clip (20) and the printed circuit board (18) of the base part.

10. The surge arrester according to claim 9,
**characterized in that**
in the longitudinal section the spring clips (20) have a V- or U-shape with two opposite legs, with one leg coming into or being in electric contact with the contact tongue (4) or the printed circuit board (18) of the base part and the other leg with the respective external connection.

11. The surge arrester according to claim 9 or 10,
**characterized in that**
the contact surfaces of the spring clips (20) are provided with slots, especially with longitudinal slots.

12. The surge arrester according to claim 11,
**characterized in that**
the slots are provided in parallel and, in the leg facing the contact surface, are passed from the end of the leg into the leg connection area.

13. The surge arrester according to one of the preceding claims,
**characterized in that**
the third printed circuit board (11) comprises a device for the wireless error and condition monitoring and/or contains temperature sensors, which are each located in the proximity of, especially opposite the protective elements (22) on the exterior printed circuit boards (10).

14. The surge arrester according to one of the preceding claims,
**characterized in that**
a spring contact bow (25) is provided between the exterior printed circuit boards (10) to produce an electrical connection.

15. The surge arrester according to claim 14,
**characterized in that**
the surface area of the third printed circuit board (11) is smaller in size than the exterior printed circuit boards (10).

16. The surge arrester according to one of the preceding claims,
**characterized in that**
on the lower top hat rail fixing side of the base part (1) the latter is provided with an opening, which exposes a grounding contact clip (17; 24) connected to the top hat rail (2).

17. The surge arrester according to claim 16,
**characterized in that**
the grounding contact clip comprises two opposite legs, with the first leg being in contact with the ground connection (17) in the base part (1) and with the second leg (24) being in connection with the top hat rail (2; 23) in such a manner that, when a current flows, the resultant magnetic force increases the contact press-on pressure.

18. The surge arrester according to one of the preceding claims,
**characterized in that**
a spring oriented in the plug-in direction of the module is inserted in the bottom of the base part (1), which, when the module is plugged in, is loaded by a pin provided on the bottom of the module and serves as an energy storing means to allow an easier removal of the module.

## Revendications

1. Dérivateur de surtensions et/ou parafoudre multipolaire de réalisation en bomier en rangée destiné à la protection d'appareils et d'installations dans les technologies informatiques, comprenant une partie de base (1) sous forme de borne traversante, des modules enfichables (3) à mettre en place dans la partie de base (1), avec des éléments protecteurs (22) et des moyens pour le montage sur profilé-chapeau, dans lequel des contacts-ressorts pour le module enfichable respectif (3) sont réalisés dans la partie de base (1) et le module enfichable (3) comprend un boîtier (13) en forme de capot qui reçoit à l'intérieur au moins une carte à circuits imprimés (10) qui porte les éléments protecteurs (22),
**caractérisé en ce que**
un cadre porteur (12) et reçu dans le boîtier du module enfichable (3), de sorte qu'une carte à circuits imprimés (10) respective se trouve sur les côtés extérieurs respectifs du cadre porteur (12), entre lesquelles est agencée une troisième carte à circuits imprimés (11), tenue par le cadre porteur (12), de telle façon que les trajets de fuite et les entrefers nécessaires sont réalisés au moyen du cadre porteur (12) entre les cartes à circuits imprimés (10 ; 11) orientées parallèlement et les éléments protecteurs (22) qui s'y trouvent, et le boîtier (13) fixe en outre l'agencement en sandwich constitué des cartes à circuits imprimés (10 ; 11) et du cadre porteur (12) en les entourant.

2. Dérivateur de surtensions selon la revendication 1,
**caractérisé en ce que** le cadre porteur (12) présente une forme rectangulaire et possède un contour extérieur avec des ressauts ou des saillies à titre de butée et de protection de détrompage pour une réalisation complémentaire des cartes à circuits imprimés (10 ; 11) respectives.

3. Dérivateur de surtensions selon la revendication 2,
**caractérisé en ce qu'**il est prévu au moins une ouverture en forme de fente (14) dans le cadre porteur (12), afin de recevoir la troisième carte à circuits imprimés (11) en la guidant.

4. Dérivateur de surtensions selon l'une des revendications précédentes,
**caractérisé en ce que** des moyens respectifs destinés à la liaison détachable par enclenchement avec des évidements d'enclenchement complémentaires sur la partie de base (1) sont prévus sur les petits côtés du boîtier.

5. Dérivateur de surtensions selon l'une des revendications précédentes,
**caractérisé en ce que** les cartes à circuits imprimés (10) fixées par les côtés extérieurs du cadre porteur (12) présentent des tronçons qui sortent, à la manière de tenons, hors du boîtier (13) du module enfichable (3) et qui forment des languettes de contact (4).

6. Dérivateur de surtensions selon la revendication 5,
**caractérisé en ce que** les tronçons sortants sont orientés les uns vers les autres avec leur côté portant un revêtement conducteur.

7. Dérivateur de surtensions selon la revendication 5 ou 6,
**caractérisé en ce que** les languettes de contact (4) présentent un revêtement en nickel.

8. Dérivateur de surtensions selon l'une des revendications 5 à 7,
**caractérisé en ce que** des ouvertures en forme de fente (5) parallèles sont prévues dans la partie de base (1), lesquelles reçoivent les languettes de contact (4) ou des extrémités des languettes de contact du module enfichable (3).

9. Dérivateur de surtensions selon la revendication 8,
**caractérisé en ce que**, dans la partie de base (1) et dans la région des ouvertures en forme de fente (5), sont agencées des cartes à circuits imprimés (18) agencées respectivement dans la direction d'enfichage, auxquelles est associé au moins un arceau fourchu à effet élastique (20), de sorte que lorsque le module enfichable (3) n'est pas enfiché, les arceaux fourchus respectifs (20) sont en contact avec le tronçon conducteur respectif des cartes à circuits imprimés (10) de la partie de base et lors de la mise en place du module enfichable (3), ce contact est interrompu par les languettes de contact (4) et une connexion est établie au moyen de languettes de contact (4) avec les arceaux fourchus (20), et l'épaisseur de la couche portante respective des languettes de contact des cartes à circuits imprimés forme l'isolation entre les arceaux fourchus (20) et la carte à circuits imprimés (18) de la partie de base.

10. Dérivateur de surtensions selon la revendication 9,
**caractérisé en ce que** les étriers fourchus (20) présentent en coupe longitudinale une forme en V ou en U avec deux branches opposées, de sorte qu'une branche vient en contact électrique ou est en contact électrique avec la languette de contact (4) ou la carte à circuits imprimés (18) de la partie de base, et l'autre branche avec la borne extérieure respective.

11. Dérivateur de surtensions selon la revendication 9 août 10,
**caractérisé en ce que** les surfaces de contact des étriers fourchus (20) sont dotées de fentes, en particulier de fentes allongées.

12. Dérivateur de surtensions selon la revendication 11,
**caractérisé en ce que** les fentes sont réalisées parallèles et sont menées, dans la branche qui est tournée vers la surface de contact, en partant de l'extrémité de la branche jusque dans la zone de jonction des branches.

13. Dérivateur de surtensions selon l'une des revendications précédentes,
**caractérisé en ce que** la troisième carte à circuits imprimés (11) comprend des moyens pour la surveillance d'erreurs et d'état sans fil et/ou des capteurs de température, qui se trouvent respectivement à proximité, en particulier à l'opposé des éléments protecteurs (22), sur les cartes à circuits imprimés extérieures (10).

14. Dérivateur de surtensions selon l'une des revendications précédentes,
**caractérisé en ce qu'**il est prévu un étrier de contact à ressort (25) pour la liaison électrique entre les cartes à circuits imprimés extérieures (10).

15. Dérivateur de surtensions selon la revendication 14,
**caractérisé en ce que** la troisième carte à circuits imprimés (11) est réalisée avec une surface plus petite que les cartes à circuits imprimés extérieures (10).

16. Dérivateur de surtensions selon l'une des revendications précédentes,
**caractérisé en ce que**, au niveau de la face intérieure de fixation de la partie de base (1), destinée au rail-chapeau, la partie de base comporte une ouverture qui dégage un contact en arceau de mise à la terre (17 ; 24), qui vient en connexion avec le rail-chapeau (2).

17. Dérivateur de surtensions selon la revendication 16,
**caractérisé en ce que** le contact en arceau de mise à la terre comprend deux branches opposées, telles que la première branche vient en contact avec la borne de mise à la terre (17) dans la partie de base (1), et la seconde branche (24) est en connexion avec le rail-chapeau (2 ; 23), de sorte que lors du passage d'un courant la force magnétique résultante augmente la pression de pressage des contacts.

18. Dérivateur de surtensions selon l'une des revendications précédentes,
**caractérisé en ce qu'**un ressort, orienté dans la direction d'enfichage du module, est mis en place dans le fond de la partie de base (1) ce ressort étant bandé lors de l'enfichage du module, par une tige prévue sur ce fond, et fait office d'accumulateur de force pour faciliter l'enlèvement du module.
